# EUROPÄISCHE PATENTSCHRIFT

(11) **EP 2 250 662 B1**
(45) Veröffentlichungstag und Bekanntmachung des Hinweises auf die Patenterteilung: **24.08.2011**
(21) Anmeldenummer: 09717051.8
(22) Anmeldetag: 28.02.2009
(51) Int. Cl.: C25F 3/12

(54) **VERFAHREN ZUR SCHNELLEN MAKROPOREN-ÄTZUNG IN N-TYP SILIZIUM**
METHOD FOR FAST MACROPORE ETCHING IN N-TYPE SILICON
PROCÉDÉ DE GRAVURE RAPIDE DE MACROPORES DANS DU SILICIUM DE TYPE N

(30) Priorität: 04.03.2008 DE 102008012479
(43) Veröffentlichungstag der Anmeldung: 17.11.2010
(73) Patentinhaber: Christian-Albrechts-Universität zu Kiel, 24118 Kiel (DE)
(72) Erfinder: OSSEI-WUSU, Emmanuel, 24114 Kiel (DE); COJOCARU, Ala, 24105 Kiel (DE); CARSTENSEN, Jürgen, 24146 Kiel (DE); FÖLL, Helmut, 24248 Mönkeberg (DE)
(74) Vertreter: Lobemeier, Martin Landolf
(86) Internationale Anmeldenummer: PCT/DE2009/000293
(87) Internationale Veröffentlichungsnummer: WO 2009/109176

(56) Entgegenhaltungen:
- DE-B3-102004 011 394
- FOLL H ET AL: "Formation and application of porous silicon" MATERIALS SCIENCE AND ENGINEERING R: REPORTS, ELSEVIER SEQUOIA S.A., LAUSANNE, CH, Bd. 39, Nr. 4, 1. November 2002 (2002-11-01), Seiten 93-141, XP004386810 ISSN: 0927-796X in der Anmeldung erwähnt
- CHRISTOPHERSEN M ET AL: "Macropore formation on highly doped n-type silicon" PHYSICA STATUS SOLIDI A WILEY-VCH GERMANY, Bd. 182, Nr. 1, 16. November 2000 (2000-11-16), Seiten 45-50, XP002533476 ISSN: 0031-8965 in der Anmeldung erwähnt

## Beschreibung

Die Erfindung betrifft ein Verfahren gemäß Anspruch 1 zur Herstellung von tiefen, zylindrischen Makroporen in n-Typ Silizium mittels elektrochemischer Ätzung unter Rückseitenbeleuchtung.

Silizium, wie auch andere Halbleiter, kann durch elektrochemische Auflösung mit Poren versehen werden. Eine grundsätzliche Einteilung nach IUPAC (International Union of Pure and Applied Chemistry) Standard in drei Klassen erfolgt nach der Größe der Poren; es wird dabei unterschieden zwischen mikroporösem Silizium (Porendurchmesser < 2 nm), Mesoporen (Porendurchmesser 2-50 nm) und Makroporen (Porendurchmesser > 50 nm). Die IUPAC Definition gilt aber nur für die Porendurchmesser; der Abstand zwischen Poren ist damit nicht grundsätzlich angesprochen, obwohl er in der Praxis meist ähnliche Größen aufweist wie der Porendurchmesser.

Zur Gestalt oder Morphologie der Poren existiert keine verbindliche Nomenklatur. In der Fachwelt ist allgemein bekannt, dass Mikroporen eine schwammartige Morphologie besitzen, während Meso- und Makroporen gerichtet sind. Bei Makroporen lassen sich insbesondere perfekt zylindrische ("kanalartige") Poren erzeugen, während Mesoporen eher verwinkelte ("korallenartige") Morphologien besitzen.

Potentielle Anwendungen für makroporöses Silizium sind beispielsweise photonische Kristalle, Mikrofiltermembranen, optische Filter, Brennstoffzellen oder Biochips. Eine der gängigen Methoden zum Ätzen von Makroporen definierter Geometrie und Anordnung in handelsüblichen n-Typ Silizium Wafern umfasst die elektrochemische Auflösung unter Verwendung eines wässrigen (aqu.) Fluorwasserstoff (HF) enthaltenden Elektrolyten unter Rückseitenbeleuchtung (Backside illumination, "bsi"). Zur besseren Reproduzierbarkeit der Porenätzergebnisse wird hierbei grundsätzlich die Beleuchtung so geregelt, dass ein vorgegebener Ätzstrom fließt. Weitere Einzelheiten sind den Druckschriften H. Föll, M. Christophersen, J. Carstensen, and G. Hasse, "Formation and application of porous silicon", Mat. Sci. Eng. R 39(4), 93 (2002) sowie H. Föll, "Properties of silicon-electrolyte junctions and their application to silicon characterization", Appl. Phys. A 53, 8 (1991) zu entnehmen. In der US 7,031,566 B2 ist beispielsweise ein Verfahren zum elektrochemischen Ätzen von Makroporen in n-Typ Silizium bekannt, bei dem die Wafer bei Verwendung einer Chlorwasserstoff enthaltenen, wässrigen Elelctrolytlösung unter Beleuchtung von ihrer Rückseite her, geätzt werden.

An die Ätzung dieser im folgenden mit n-makro(aqu., bsi) bezeichneten Poren werden je nach Verwendungszweck bestimmte Anforderungen gestellt, die im Einzelnen sehr detailliert sein können, aber im Allgemeinen immer drei Parameter enthalten:
1. Erreichbare maximale Tiefe aₘₐₓ der geätzten Poren.
2. Ätzzeit *t*_{etch} bis zur gewünschten Tiefe *a*, oder, damit gleichbedeutend, mittlere Ätzgeschwindigkeit *v*_{etch}=*a* / t_{etch}.
3. Rauhigkeit *r*ₚ der Porenwände, gemessen z.B. mit einem Atomic Force Microscope (AFM) als "root mean square" (rms) des Oberflächenprofilverlaufes.

Weitere Anforderungen mögen darüber hinaus existieren, z.B. ein gegenüber Porentiefe möglichst konstanter Porendurchmesser oder eine Vorgabe der Querschnittsform der Pore (z.B. rund - eckig). Diese sollen aber im Folgenden außer Acht gelassen werden.

Die drei oben genannten Parameter stehen in einer nichtlinearen Abhängigkeit voneinander, die bis heute nicht vollständig verstanden ist. Es können bislang allenfalls einige Faustregeln formuliert werden, so zum Beispiel, dass hohe Ätzgeschwindigkeiten *v*ₑₜₑₕ und große maximale Ätztiefen aₘₐₓ "entgegen gesetzte" Anforderungen darstellen - will man tief ätzen, muss man das in der Regel langsam tun. Aber auch bei sehr langsamem Ätzen wird man über bestimmte Ätztiefen nicht hinauskommen. Eine simple Relation der Form *v*_{etch} × *a*ₘₐₓ = konst. wird der Komplexität des Systems deshalb auch nicht gerecht. Ähnliches gilt für die Rauhigkeit *r*ₚ der Porenwände. Die an sich nahe liegende Vermutung, dass große Ätzgeschwindigkeiten rauere Porenwände bedingen, erweist sich als unzutreffend. Auch Zusammenhänge zwischen Porentiefe und Porenwandrauhigkeit dürfen unterstellt werden, sind aber nicht bekannt.

In der Praxis existieren heute bei gegebenem Optimierungsbedarf an einem oder mehreren der genannten drei Parameter keine klaren Verfahrensanweisungen. Überdies bestehen nach wie vor Limitierungen der elektrochemischen Porenätzung, d.h. über gewisse Begrenzungen gelangen diese Parameter nach dem Stand der Technik nicht hinaus.

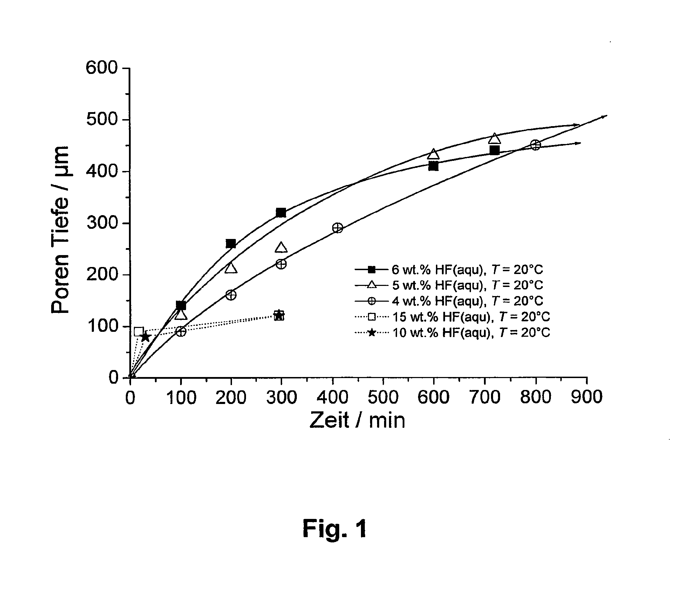

Während schnelles Wachstum für Meso- und Mikroporen in n-Typ Silizium allgemein bekannt ist, liegt der heutige Grenzwert der Ätzgeschwindigkeit für tiefe, zylindrische Makroporen bei ungefähr 1 Mikrometer/Minute. Zwar wurde bereits versucht, die Wachstums geschwindigkeit konventioneller Makroporen durch geeignete, nahe liegende Maßnahmen zu erhöhen, insbesondere durch Erhöhung der HF-Konzentration oder der Temperatur. Dies führt aber nur zu höheren Wachstumsgeschwindigkeiten in der Anfangsphase und bewirkt schließlich den Verlust der Porenstabilität und die Terminierung des Porenwachstums (vgl. Fig. 1).

Das Problem liegt dabei in der Zunahme des Stromanteils durch die bereits gebildeten Wände einer Pore; dieser wird Leckstrom genannt. Die während der Ätzung kontinuierlich anwachsende Porenwandfläche bewirkt eine allmähliche Verschiebung des Verhältnisses von Leckstrom aus den Porenwänden zu photogeneriertem Ätzstrom von den Porenspitzen hin zu größeren Werten. Dadurch wird einerseits die Kontrolle der Porengeometrien mit wachsender Porentiefe immer schwieriger. Andererseits zeigt sich bei Verwendung einer hohen HF-Konzentration die Tendenz, dass ab einer gewissen Porentiefe vor allem die Porenwände in der Nähe der Porenspitzen geätzt werden. Die Porenspitzen verbreitern sich dann - was sie letztlich zerstört - alle Porenspitzen wachsen zusammen und bilden eine sogenannte "Cavity". Eine geringe HF-Konzentration lässt die Porenwände demgegenüber länger stabil und erlaubt das Vorantreiben der Poren in größere Tiefen.

Alle bisherigen Erfahrungen kumulieren in der Regel, dass tiefe Makroporen in n-Typ Silizium mit guter zylindrischer Geometrie nur für HF Konzentration im Bereich 2 - 5 % und Stromdichten von 1-10 mA/cm² darstellbar sind. Bestenfalls sind schnell wachsende zylindrische Makroporen heute für geringe Tiefen im Bereich einiger Mikrometer bis ca. 100 µm möglich; tiefe zylindrische Makroporen (im Längenbereich 300 µm-600 µm) können nicht mit hoher Wachstumsgeschwindigkeit dargestellt werden.

Als eine bemerkenswerte Ausnahme von der vorgenannten Regel ist die von den Erfindern stammende Patentschrift DE 10 2004 011 394 B3 zu nennen, in der auch teilweise die Daten aus Fig. 1 dieser Beschreibung zu finden sind. Bei dem dort beschriebenen Verfahren werden die Poren jedoch nicht unter Rückseitenbeleuchtung, sondern mittels Lawinendurchbruch an der Porenspitze geätzt, was das Anlegen sehr hoher Ätzspannungen verlangt und auch eine sehr hohe HF-Konzentration voraussetzt. So können tiefe, zylindrische Makroporen mit Ätzgeschwindigkeiten bis zu erstaunlichen 8 Mikrometer/Minute erzeugt werden. Jedoch geschieht dies in einem speziellen, in der DE 10 2004 011 394 B3 erstmals beschriebenen "Porenwachstumsmodus", der insbesondere keine Kontrolle über die Anordnung oder die Beabstandung der Poren zulässt. Es sind hier vielmehr hohe Porendichten erforderlich, weil gerade die enge Nachbarschaft der Poren die Stabilität der Porenwände gegen den hochkonzentrierten Elektrolyten gewährleistet. Insofern ist der Nutzen dieses beschleunigten Ätzens vor allem auf die Erzeugung perforierter Membranen mit hoher Porendichte beschränkt.

Die maximal erreichbare Porentiefe *a*ₘₐₓ für n-makro(aqu., bsi) Poren bei einer HF-Konzentration um etwa 5 Gewichts-% liegt bei 400-500 Mikrometer. Dabei sind allerdings schon besondere Maßnahmen vorzusehen, z.B. eine Absenkung der Temperatur von ca. 20 °C auf etwa 10 °C während der Ätzung sowie die kontinuierliche Steigerung der angelegten Spannung von 0.5 V auf 0.6 V. Gleichzeitig muss durch eine systematische Rücknahme des Ätzstromes einer Verbreiterung der Porendurchmesser entgegengewirkt werden. Porentiefen im genannten Bereich bis 500 Mikrometer können i. a. nur erreicht, wenn keine Rücksicht auf die gleichzeitige Optimierung von Ätzgeschwindigkeit und Porenwandrauhigkeit genommen wird. Im Endergebnis wird man mittlere Ätzgeschwindigkeiten bis zu 1 µm/min und Wandrauhigkeiten im Bereich um 50 nm rms erwarten müssen.

Der Fachmann weiß, dass der Ätzprozess sehr empfindlich auf kleinste Abweichungen von optimalen Zeitverläufen reagiert. Das zweckmäßige Prozessfenster ist gewöhnlich sehr klein und muss fallweise immer wieder neu bestimmt werden. Darüber hinaus können Zusätze zum Elektrolyten hilfreich sein, z.B. Tenside in kleinen Mengen oder größere Mengen von Ethanol. Vielfach wird insbesondere Essigsäure in geringer Konzentration zugesetzt, um die Benetzung der hydrophoben Si-Oberfläche durch den wässrigen Elektrolyten zu verbessern. Grundsätzlich sind wenige Details zu dieser Fragestellung bekannt, da sie in der Regel nicht veröffentlicht werden.

Die Porenwandrauhigkeit wurde bisher wenig untersucht; bekannt sind nur die von E. Foca, J. Carstensen, M. Leisner, E. Ossei-Wusu, O. Riemenschneider, and H. Föll, "Smoothening the pores walls in macroporous n-Si", ECS Transactions, 211th Meeting of The Electrochemical Society, Chicago 6(2), 367 (2007) publizierten Ergebnisse. Dort wird gezeigt, dass eine Herabsetzung der Wandrauhigkeiten - wichtig für optische Anwendungen - erzielt werden kann ohne dass die maximale Porentiefe leidet, indem verschiedene Alkohole (Methanol, Ethanol, Propanol) dem Elelctrolyten zugemischt werden, generell hat das aber tendenziell eine weitere Verringerung der Ätzgeschwindigkeit zur Folge.

Aus Kostengründen wird man stets anstreben, die Ätzdauer t_{etch} im Bereich üblicher Einzelprozesszeiten, d.h. einige Minuten, zu halten. Zu Ätztiefen von 400-500 µm gehören aber heute Ätzzeiten von *t*_{etch} ≈ 500-800 min. Damit ist ein kostengünstiger Einsatz von makroporösem Silizium nur bedingt möglich.

Es ist daher die Aufgabe der Erfindung, ein verbessertes Verfahren zur Herstellung tiefer, zylindrischer Makroporen in n-Typ Silizium anzugeben, das einen beschleunigten Ätzvorgang bei gleich bleibender oder verringerter Porenwandrauhigkeit und sogar bis zu größeren Porentiefen erlaubt.

Die Aufgabe wird gelöst durch ein Verfahren mit den Merkmalen des Anspruchs 1. Die Unteransprüche geben vorteilhafte Ausgestaltungen an.

Das erfindungsgemäße Verfahren geht von dem üblichen elektrochemischen Ätzprozess unter Rückseitenbeleuchtung bei ebenfalls gängigen Ätzparametern (Ätzspannung in der Größenordnung 1 V, Stromdichte zwischen etwa 1 und 10 mA/cm², Temperatur konstant um etwa 20 °C) aus. Es wird ausschließlich der verwendete Elektrolyt hinsichtlich seiner Zusammensetzung modifiziert. Denn wie sich experimentell erwiesen hat, ist ein Elektrolyt bestehend aus einem Wasser/Essigsäure-Gemisch als Lösungsmittel mit einem Mischungsverhältnis H₂O:CH₃COOH zwischen 2 : 1 und 7 : 3 und einer HF-Konzentration in der Umgebung von 10 Gewichtsprozent HF (i. F. kurz: Essigsaurer Elektrolyt) für die beschleunigte Erzeugung tiefer, zylindrischer Poren bestens geeignet, was dem Fachmann geradezu abwegig erscheinen muss.

Denn zum einen ist die traditionelle Funktion der Essigsäure die einer Benetzungshilfe und - in größeren Konzentrationen wie bei der nasschemischen Ätzung-auch die eines Verdünners, d.h. ihr wird normalerweise keine signifikante Beteiligung an chemischen Reaktionen beim Ätzprozess unterstellt.

Und zum anderen wurde zwar bereits in Publikationen (Christophersen et al., "Macropore Formation on Highly Doped n-Type Silicon", Phys. Stat. Sol. 2000, 182, 1:45-50 und Bao et al., "Macropore Formation Without Illumination on Low Doped n-Type Silicon", Journal of The Electrochemical Society, 154, D175-D181, 2007) angedeutet, eine hohe Konzentration von Essigsäure in HF-haltigem Elektrolyt könne womöglich als Oxidationsmittel wirken, um insbesondere Makroporen elektrochemisch ohne Rückseitenbeleuchtung zu ätzen, aber dieselben Publikationen warten weder mit Ergebnissen hierzu auf noch kann man ihnen irgendeinen Hinweis entnehmen, dass dies gut gelingen würde.

Tatsächlich müsste der Fachmann nach Quellenlage somit davon ausgehen, dass die oben genannte Essigsäurekonzentration des Elektrolyten im Ergebnis entweder wirkungslos oder sogar kontraproduktiv wäre, denn beim Porenätzen unter Rückseitenbeleuchtung verschiebt sich das Verhältnis von Siliziumoxid-Bildung zu Materialauflösung und -abtrag mit wachsender Porentiefe ohnehin schon zur Oxidbildung, was das Porenwachstum ausbremst. Das Zusetzen eines "Oxidationsmittels" macht da erst recht keinen Sinn.

Die durchgeführten Experimente zeigen demgegenüber unerwartet die Grundregel, dass der Essigsäurezusatz sowohl die maximale Ätztiefe *a*ₘₐₓ gegenüber dem bisherigen Maximalwert stark erhöht (und nicht, wie bei 10% HF Lösung in Wasser zu erwarten wäre, stark erniedrigt), dabei aber die bisher erzielten maximalen Ätzgeschwindigkeiten v_{*e*tch} nicht (wie ohne Essigsäure zu erwarten wäre) noch weiter reduziert, sondern stark erhöht. Darüber hinaus muss die Temperatur nicht mehr-mit sonst erheblichem Aufwand und signifikant verlängerten Ätzzeiten-erniedrigt werden. Der Absolutwert der Ätzspannung zeigt einen Offset zu den Ergebnissen ohne Essigsäure, doch der exakte Wert der Spannung ist verhältnismäßig unwichtig, d.h. es liegt jetzt gegenüber dem Stand der Technik ein sehr viel größeres Prozessfenster vor.

Es sollte betont werden, dass man bei signifikanten Abweichungen der jeweiligen Konzentrationen von HF und Essigsäure von den oben genannten Werten bzw. Intervallen den Bereich der Gesamtoptimierung verlässt. Dies bedeutet zugleich, es existiert kein systematischer Weg, von den herkömmlichen Elelctrolytzusammensetzungen durch allmähliche Variation der jeweiligen Konzentrationen der Einzelsubstanzen allein zum beschriebenen Optimum zu gelangen. Dies ist erst durch die Annahme eines Zusammenhanges zwischen CH₃COOH und HF möglich, der bislang nie unterstellt wurde und auch hier nicht erklärt werden kann.

Die Erfindung wird nachfolgend noch näher erläutert anhand der Abbildungen und zweier Ausführungsbeispiele. Dabei zeigt:
- Fig. 1: ein Diagramm zur Darstellung der erreichten Porentiefe aufgetragen gegen die dafür erforderliche Ätzzeit für verschiedene HF-Konzentrationen in Wasser bei 20 °C nach dem Stand der Technik;
- Fig. 2: die Elektronenmikroskop-Aufnahme einer nach der Lehre der Erfindung erzielten Porenanordnung mit vergrößerter Darstellung einiger Porenspitzen;
- Fig. 3: eine Aufnahme von geätzten Poren, die mit dem erfindungsgemäßen Verfahren erzeugt wurden, wobei zusätzlich die Viskosität des Elektrolyten erhöht worden ist;
- Fig. 4: ein Diagramm analog zu Fig. 1, in dem die mit der Erfmdung erzielten Resultate im Vergleich mit der "5 % HF"-Kurve aus Fig. 1 dargestellt sind.

Bereits in der Diskussion des Standes der Technik wird angesprochen, dass dem Wunsch nach erhöhter Ätzgeschwindigkeit für tiefe Poren nicht durch schlichtes Steigern der HF-Konzentration beizukommen ist. Fig. 1 zeigt die Vergeblichkeit dieser Herangehensweise sehr deutlich. Darin ist klar erkennbar, dass bei höheren HF Konzentrationen die Ätzung zwar anfänglich schneller läuft, dafür aber früher verlangsamt und die letzten Endes erreichbare Ätztiefe abnimmt. Eingezeichnet sind außerdem Daten für 10 % und 15 % HF Konzentration, die sich voneinander kaum unterscheiden und aus denen ersichtlich ist, dass nur Ätztiefen bis etwa 100 Mikrometer erzielt werden.

### Ausführungsbeispiel 1

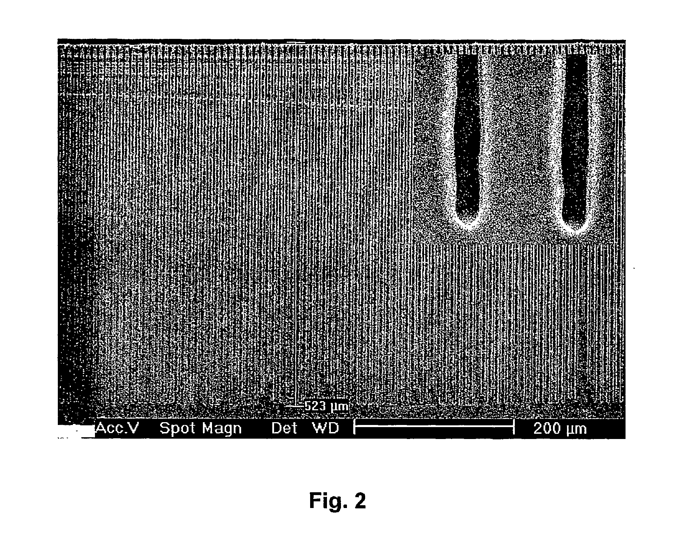

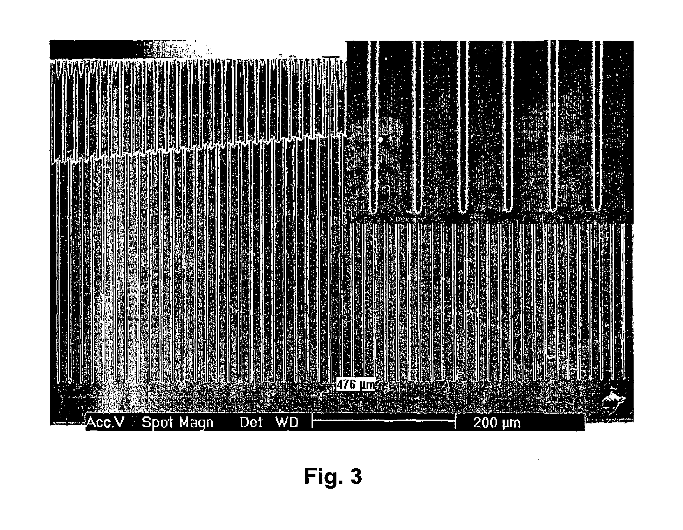

Verwendet man nun den Essigsauren Elektrolyten, so sind die bisherigen allgemein anerkannten Beschränkungen offenbar außer Kraft gesetzt, wie das in Fig. 2 gezeigte Resultat belegt. Die konkreten Bedingungen des Ätzprozesses zur Erzeugung dieses Resultats sind: Spannung 0.6 V konstant für die ersten 50 min, danach linear ansteigend auf 1.5 V bis zum Ende des Experimentes; Strom von 11 mA/cm² abfallend bis auf 4 mA/cm², Ätzdauer 325 min., Si(100) 20-30 Ω·cm, Elektrolyttemperatur 20 °C, 200 ml Wasser +100 ml Essigsäure + 64 ml HF (48 %). Ein Elelctrolyt nach dieser Rezeptur weist 9,4 Gewichtsprozent HF auf. Die Ergebnisse ähneln sich sehr in einem günstigen Bereich um 10 Gewichtsprozent HF, d.h. die in den Fig. 2 und 3 gezeigten Resultate sind für die Umgebung von 10 % HF repräsentatitv.

Man erhält Makroporen mit guter Geometrie, mittel guter Wandrauhigkeit und einer Tiefe von 523 µm. Größere Tiefen wären möglich, sind aber mit den hier gewählten Wafern (Gesamtdicke 550 µm) nicht darstellbar. Die gesamte Ätzzeit beträgt 325 min oder 5,4 Stunden; die mittlere Ätzgeschwindigkeit ist damit 1.6 µm/min, also etwa 2,5 mal schneller als bei der herkömmlichen Technik, mit der überdies Porentiefen von 520 µm kaum erreichbar sind.

Es lassen sich auch mit HF-Konzentrationen deutlich oberhalb von 10 % noch Makroporen herstellen. Insbesondere gelingt dies mit Essigsaurem 15 % Elektrolyten, wobei allerdings die Porentiefe etwa auf 200 Mikrometer begrenzt ist und die Poren keine sehr glatten Wände mehr besitzen (Ergebnisse nicht dargestellt). Im Grunde zeigt das Wachstum auch hier das Verhalten der Kurven aus Fig. 1 für hohe HF-Konzentrationen. Durch die Zugabe des erfindungsgemäß großen Anteils an Essigsäure können nun aber doppelt so tiefe Poren mit erhöhter Geschwindigkeit geätzt werden. Ist man hingegen vorrangig an "schönen" Poren interessiert, sollte man bevorzugt die HF-Konzentration im Optimum um 10 % HF einrichten.

Eine bevorzugte Ausgestaltung der Erfindung besteht darin, den Essigsauren Elektrolyten zusätzlich mit einem Salz zu versetzen, um seine Viskosität zu erhöhen (i. F. kurz: Viskoser Essigsaurer Elelctrolyt). Als besonders vorteilhaft erweist sich hierfür die Zugabe von Carboxylmethylcellulose Natriumsalz (0.5 g-5 g auf 1000 ml).

Die möglichen Vorteile einer Viskositätserhöhung sind inzwischen als Stand der Technik anzusehen. Es ist bekannt, dass hierdurch Poren mit verringerter Wandrauhigkeit erzielt werden können-zumeist um den Preis einer Einbuße an Ätzgeschwindigkeit. Gelegentlich lassen sich mit viskosen Elektrolyten sogar größere Ätztiefen und -geschwindigkeiten erzielen als mit den herkömmlichen wässrigen Elektrolyten. Aber allgemeingültige Aussagen sind nach dem heutigen Kenntnisstand nicht möglich.

Ein Viskoser Essigsaurer Elektrolyt ist also eine Erprobung wert, und man gelangt zu experimentellen Resultaten, die die Ergebnisse herkömmlicher Ätztechniken eindeutig übertreffen. Mit einem auf die jeweilige Aufgabe abgestimmten Viskosen Essigsauren Elektrolyten lassen sich sowohl große Ätztiefen als auch hohe Ätzgeschwindigkeiten bei sehr glatten Porenwänden erzielen. Je nach Anforderungsprofil werden darüber hinaus die Temperatur und die Spannung womöglich auch anzupassen sein, doch grundsätzlich ist das Prozessfenster immer noch viel größer als bei der herkömmlichen Technik.

### Ausführungsbeispiel 2

Fig. 3 zeigt eine Aufnahme des vorgenannten Ätzresultats mit dem Viskosen Essigsauren 9,4% Elektrolyt. Die Parameter des Experiments lauten im Detail:
Spannung 0.6 V konstant für die ersten 50 min, danach linear ansteigend auf 1.5 V bis zum Ende des Experimentes; Strom von 10 mA/cm² abfallend bis auf 3 mA/cm², Ätzdauer 320 min., Si(100) 20-30 Ω·cm, Elektrolyttemperatur 20°C, 200 ml Wasser + 100 ml Essigsäure + 64 ml HF (48 %) + 2g Carboxylmethylcellulose Natriumsalz, d.h. Viskoser Essigsaurer 9,4 % Elektrolyt.

Man erhält Makroporen mit guter Geometrie, geringer Wandrauhigkeit und einer Tiefe von 476 µm. Gegenüber dem Ausführungsbeispiel 1 ist die Ätztiefe jetzt etwas reduziert, dafür ist die Rauhigkeit geringer, wie man am Inlay-Bild gut sehen kann. Die Ätzgeschwindigkeit liegt im Mittel immer noch bei fast 1,5 µm/min.

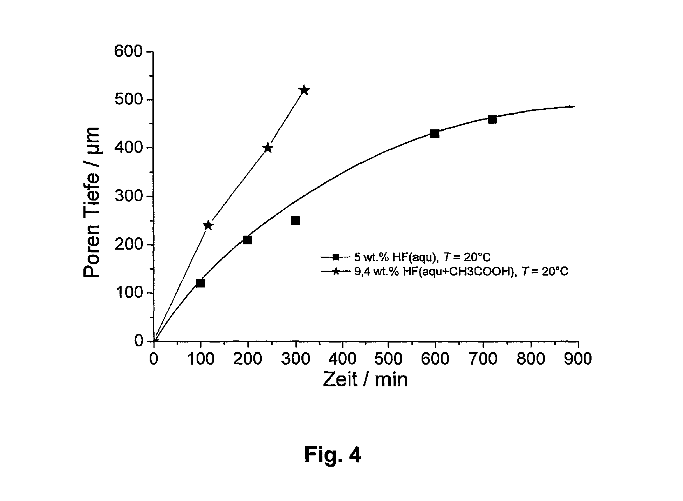

In Fig. 4 schließlich sind Messwerte für Porentiefe und Ätzdauer in Analogie zu Fig. 1 dargestellt, die mit dem erfindungsgemäßen Verfahren erzielt worden sind. Die durchgezogene Kurve repräsentiert die "5 % HF"-Kurve aus Fig. 1 zum Vergleich, also das derzeitige Optimum im Stand der Technik.

Die Wahl der benutzten Wafer ließ keine tiefere Porenätzung zu, aber insbesondere mit Blick auf den Anstieg der Messwerte für den Essigsauren 9,4 % Elektrolyt darf man sicher erwarten, dass Ätztiefen weit jenseits 500 µm realisierbar sind.

Auch der Viskose Essigsaure 9,4 % Elektrolyt lässt offenbar größere Ätztiefen als bisher zu. Zwar opfert man einen Teil des durch die Erfindung erzielten Gewinns an Ätzgeschwindigkeit zugunsten "schönerer" Poren, aber selbst dabei liegt man erkennbar besser als es bisher überhaupt möglich erschien.

Zusammenfassend lautet die Lehre der Erfindung:
Wer n-makro(aqu., bsi) Poren schnell und tief herstellen will, sollte dem Elektrolyten ungefähr 30 % Essigsäure beimengen und die HF-Konzentration auf ungefähr 10 % steigern.
Die bisherige "5 %-Schallmauer" ist durchbrochen. Wer tiefe und möglichst glatte n-makro(aqu., bsi) Poren erzeugen will, sollte dasselbe tun, zusätzlich die Viskosität erhöhen,
und sich auch etwas Zeit nehmen, die Ätzparameter mit einiger Sorgfalt seiner konkreten Zielsetzung angemessen auszuwählen.

## Patentansprüche

1. Verfahren zum elektrochemischen Ätzen von Makroporen in n-Typ Siliziumwafern unter Beleuchtung der Waferrückseiten bei Verwendung eines wässrigen Elektrolyten, **dadurch gekennzeichnet, dass** der Elektrolyt eine wässrige essigsaure Lösung mit der Zusammensetzung H₂O: CH₃COOH aus dem Intervall zwischen 2 : 1 und 7 : 3 mit einer Beimengung von wenigstens 9 Gewichtsprozent Fluorwasserstoff ist.

2. Verfahren nach Anspruch 1, **dadurch gekennzeichnet, dass** der Elektrolyt zur schnellen Erzeugung von Makroporen mit einer Tiefe bis 200 Mikrometer eine HF-Konzentration zwischen 9 und 15 Gewichtsprozent hat.

3. Verfahren nach Anspruch 2, **dadurch gekennzeichnet, dass** der Elektrolyt zur Erzeugung von Makroporen mit einer Tiefe größer als 500 Mikrometer einer HF-Konzentration zwischen 9 und 11 Gewichtsprozent hat.

4. Verfahren nach einem der vorangehenden Ansprüche, **dadurch gekennzeichnet, dass** dem Elektrolyten ein seine Viskosität erhöhendes Salz beigemengt ist.

5. Verfahren nach Anspruch 4, **dadurch gekennzeichnet, dass** dem Elektrolyten Carboxylmethylcellulose Natriumsalz in einer Konzentration zwischen 0.5 g und 5 g auf 1000 ml beigemengt ist.

## Claims

1. A method for electrochemically etching macropores in n-type silicon wafers under illumination of the wafer rear side by use of an aqueous electrolyte, **characterized in that** the electrolyte is an aqueous acetic acid solution of a composition comprising H₂O:CH₃COOH in the interval of 2:1 and 7:3 with an admixture of at least 9 % by weight of hydrogen fluoride.

2. The method according to Claim 1, **characterized in that** the electrolyte has an HF concentration between 9 and 15 % by weight for the fast generation of macropores having a depth up to 200 micrometers.

3. The method according to Claim 2, **characterized in that** the electrolyte has an HF concentration between 9 and 11 % by weight for the generation of macropores having a depth of more than 500 micrometers.

4. The method according to one of the preceding claims, **characterized in that** there is added to the electrolyte a salt that increases its viscosity.

5. The method according to Claim 4, **characterized in that** sodium salt having a concentration between 0.5g and 5g per 1000mL is added to the electrolyte carboxyl methyl cellulose.

## Revendications

1. Procédé pour la gravure électrochimique de pores macroscopiques dans des tranches de silicium de type n sous éclairage des faces arrières des tranches en utilisant un électrolyte aqueux, **caractérisé par le fait que** l'électrolyte est une solution aqueuse acétique ayant comme composition H₂O : CH₃COOH de l'intervalle entre 2 : 1 et 7 : 3 avec une addition de fluorure d'hydrogène d'au moins 9 pourcent par poids.

2. Procédé selon la revendication 1, **caractérisé par le fait que** l'électrolyte, pour une génération rapide de pores macroscopiques avec une profondeur jusqu'à 200 micromètres, dispose d'une concentration HF entre 9 et 15 pourcent de poids.

3. Procédé selon la revendication 2, **caractérisé par le fait que** l'électrolyte, pour une génération rapide de pores macroscopiques avec une profondeur supérieure à 500 micromètres, dispose d'une concentration HF entre 9 et 11 pourcent de poids.

4. Procédé selon une des revendications ci-dessus, **caractérisé par le fait qu'**un sel augmentant la viscosité de l'électrolyte est ajouté à celui-ci.

5. Procédé selon la revendication 4, **caractérisé par le fait que** de la carboxyméthylcellulose sodique d'une concentration entre 0.5 g et 5 g sur 1000 ml est ajoutée à l'électrolyte.
